# FASCICULE DE BREVET EUROPEEN

(11) **EP 4 206 601 B1**
(45) Date de publication et mention de la délivrance du brevet: **26.03.2025**
(21) Numéro de dépôt: 22216806.4
(22) Date de dépôt: 27.12.2022
(51) Int. Cl.: F28D 15/02

(54) **DISPOSITIF D'ECHANGE THERMIQUE ET MATERIEL COMPRENANT LE DISPOSITIF D'ECHANGE THERMIQUE**
WÄRMETAUSCHERVORRICHTUNG UND AUSRÜSTUNG MIT DER WÄRMETAUSCHERVORRICHTUNG
HEAT EXCHANGE DEVICE AND EQUIPMENT INCLUDING THE HEAT EXCHANGE DEVICE

(30) Priorité: 29.12.2021 FR 2114633
(43) Date de publication de la demande: 05.07.2023
(73) Titulaire: THALES, 92190 Meudon (FR)
(72) Inventeur: HUGON, Julien, 06156 CANNES LA BOCCA Cedex (FR); CHAIX, Alain, 06156 CANNES LA BOCCA Cedex (FR); JAMIN, Aymeric, 06156 CANNES LA BOCCA Cedex (FR); RAYNAUD, Martin, 06156 CANNES LA BOCCA Cedex (FR)
(74) Mandataire: Atout PI Laplace

(56) Documents cités:
- US-A- 5 960 866
- US-A1- 2021 341 185
- US-B1- 7 342 787

## Description

### DOMAINE TECHNIQUE

Cette invention concerne des dispositifs d'échange thermique, et en particulier, des dispositifs d'échange thermique comprenant des échangeurs thermiques. L'invention concerne également un matériel comprenant plusieurs équipements dissipatifs et un dispositif d'échange thermique permettant de les maintenir dans une plage de température donnée.

### ARRIÈRE-PLAN

Les équipements dissipatifs pour les applications spatiales, tels que les antennes rayonnantes de satellite, ou les amplificateurs permettant d'amplifier des signaux émis ou reçu par des éléments rayonnants, nécessitent l'utilisation d'échangeurs thermiques permettant de récupérer la chaleur dissipée par les équipements et contrôler leur température. En particulier, les échangeurs thermiques comprennent un fluide circulant à proximité des équipements et récupérant la chaleur dissipée. Cependant, lorsque le fluide est à l'état liquide, le coefficient d'échange thermique est faible. Au contraire, un état diphasique du fluide permet de garantir un coefficient d'échange thermique élevé entre le fluide et les équipements dissipatifs. Ainsi, certains échangeurs nécessitent l'utilisation de réchauffeurs en entrée des échangeurs thermiques afin de garantir un écoulement diphasique dès l'entrée de l'échangeur thermique. Alternativement, certains échangeurs nécessitent un surdimensionnement du contrôle thermique afin de prendre en compte une perte de performance liée à un écoulement liquide en début d'échangeur. De plus, afin d'assurer l'homogénéité des caractéristiques des éléments rayonnants, il est important d'avoir une homogénéité thermique des éléments rayonnants.
US7342787B1 divulgue un appareil pour refroidir un composant informatique, comprenant un système de compression de vapeur, comprenant un évaporateur couplé au composant informatique ; un condenseur couplé à l'évaporateur ; un compresseur couplé à l'évaporateur et au condenseur ; et un module thermoélectrique (TEM) comprenant un côté chaud et un côté froid ; le côté froid du TEM étant connecté au condenseur ; et le côté froid du TEM pouvant fonctionner pour absorber la chaleur du condenseur.
US 2021/341185 A1 divulgue un système de refroidissement à deux phases à ébullition de flux, caractérisé en ce qu'un appareil à circuit hydraulique fermé d'un fluide frigorigène à transfert de chaleur est fourni, comprenant : - des moyens pour pomper un fluide frigorigène qui, au moins dans certains segments du circuit, est à deux phases liquide-vapeur ou multiphase, - un dissipateur de chaleur-évaporateur configuré pour transférer de la chaleur par conduction depuis un composant à refroidir vers le fluide frigorigène, - un condenseur, capable de condenser la vapeur qui se développe sur l'évaporateur tout en dissipant simultanément la chaleur fournie par le fluide frigorigène à la fois par conduction, convection et rayonnement et par condensation dans l'environnement, - un réservoir qui sert également de cuve d'expansion, ou un réservoir et une cuve d'expansion qui sont distincts et raccordés l'un à l'autre, - une pluralité de capteurs, comprenant des capteurs de débit, de pression et de température et un système de commande électronique de la pompe.
US 5960866 divulgue une unité de refroidissement pour dispositifs électroniques, le procédé de fabrication comprenant les étapes consistant à : (a) préparer un bloc métallique de type plaque pour éliminer la chaleur générée par un composant électronique, le bloc métallique comportant des trous dans la partie épaisse du un bloc métallique et ayant des parties convexes formées sur une surface principale ou sur les deux surfaces principales du bloc métallique ; (b) insérer des caloducs dans les trous ; et (c) appliquer une force locale et bidimensionnelle depuis la surface du bloc métallique sur les parties convexes pour rendre la surface plate, amenant la surface externe de chaque caloduc en contact étroit avec la paroi interne de chaque trou dans le bloc métallique.

### RÉSUMÉ

Afin de pallier les inconvénients des dispositifs d'échange thermique, l'invention propose un système permettant de garantir au moins un canal ayant un écoulement diphasique à proximité d'équipements dissipatifs et assurant un coefficient d'échange thermique élevé sans avoir besoin d'un réchauffeur en entrée d'un échangeur thermique et sans avoir besoin de surdimensionner le contrôle thermique associé.

A cet effet, l'invention a pour objet un dispositif d'échange thermique comprenant un échangeur thermique ayant un écoulement comprenant plusieurs canaux dans lesquels un fluide s'écoule en sens opposé et le fluide est à dans un état diphasique dans au moins un des canaux.

L'invention vient à améliorer la situation en proposant un dispositif d'échange thermique comprenant une boucle thermique dans laquelle circule un fluide, la boucle thermique comprenant : un échangeur thermique comprenant au moins deux tubes métalliques disposés parallèlement, le fluide circulant dans un premier sens dans un des deux tubes et dans un deuxième sens opposé au premier sens dans l'autre tube ; une semelle métallique sur laquelle les deux tubes sont fixés ; une pompe configurée pour faire circuler le fluide dans les deux tubes métalliques avec un débit ; un condenseur pour évacuer de la chaleur du fluide, où des conditions d'écoulement du fluide sont adaptées pour permettre au fluide d'être dans un état diphasique dans un des deux tubes, les conditions d'écoulement comprenant le débit du fluide et une dimension des tubes ; et un réchauffeur configuré pour transférer de l'énergie thermique d'un canal reliant une sortie de l'échangeur à une entrée du condenseur vers un canal reliant une sortie de la pompe vers une entrée de l'échangeur.

Dans un mode de réalisation, les aux moins deux tubes métalliques sont connectés en série.

Dans un mode de réalisation, les aux moins deux tubes métalliques sont connectés en parallèle.

Dans un mode de réalisation, le dispositif d'échange thermique comprend un premier capteur de température configuré pour mesurer une première température du fluide circulant entre la pompe et l'échangeur thermique.

Dans un mode de réalisation, le dispositif d'échange thermique comprend un second capteur de température configuré pour mesurer une deuxième température du fluide circulant entre l'échangeur thermique et le condenseur.

Dans un mode de réalisation, le fluide circule dans un état liquide dans la pompe.

Dans un mode de réalisation, le fluide est de l'ammoniac.

De plus, l'invention vient à améliorer la situation en proposant un matériel comprenant un dispositif d'échange thermique selon l'une des revendications précédentes et plusieurs équipements dissipatifs disposés sur la semelle métallique, les équipements dissipatifs étant alignés avec les au moins deux tubes métalliques de façon à ce que chaque équipements dissipatifs échange de la chaleur avec le fluide circulant dans chacun des au moins deux tubes métalliques.

### BRÈVE DESCRIPTION DES DESSINS

L'invention sera mieux comprise et d'autres avantages apparaîtront à la lecture de la description qui va suivre donnée à titre non limitatif et grâce aux figures parmi lesquelles :
La figure 1 illustre un exemple de dispositif d'échange thermique ;
Les figures 2 et 3 représentent un exemple d'antenne électronique à balayage équipée d'un dispositif d'échange thermique selon l'invention ;
La figure 4 illustre un dispositif d'échange thermique non conforme à l'invention ;
La figure 5 illustre un dispositif d'échange thermique selon l'invention ; et
La figure 6 illustre un dispositif d'échange thermique non conforme à l'invention.

### DESCRIPTION DÉTAILLÉE

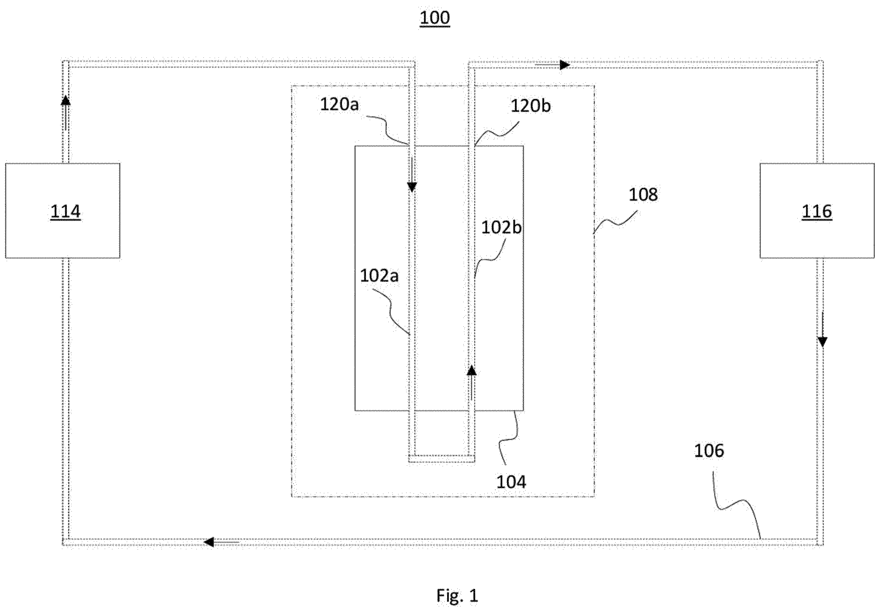

La figure 1 illustre un exemple de dispositif d'échange thermique 100. Le dispositif d'échange thermique 100 comprend une boucle thermique 106 dans laquelle circule un fluide caloporteur. Le fluide peut être par exemple à base d'ammoniac, de pentafluoropropane ou tetrafluoroethane (type « fréon », produits vendus par la société DuPont de Nemours). La boucle thermique 106 comprend un échangeur thermique 108 comprenant deux tubes métalliques 102a, 102b disposés parallèlement, le fluide circulant dans un premier sens dans un des deux tubes et dans un deuxième sens opposé au premier sens dans l'autre tube. Dans cet exemple, les deux tubes métalliques 102a, 102b sont connectés en série. En particulier, l'échangeur thermique 108 comprend une entrée du fluide 120a au niveau du tube métallique 102a et une sortie du fluide 120b au niveau du tube métallique 102b, les deux tubes 102a, 102b étant connectés par un tube permettant au fluide de circuler du tube métallique 102a au tube métallique 102b. La boucle thermique 106 comprend également une semelle métallique 104 sur laquelle les deux tubes 102a, 102b sont fixés. En pratique, les deux tubes 102a et 102b peuvent être fixés sur une face externe de la semelle 104, ou même noyés dans la semelle 104. Des équipements dissipatifs peuvent être fixés sur la semelle métallique 104, par exemple sur la surface opposée à la surface sur laquelle les deux tubes métalliques 102a, 102b sont fixés. Les équipements dissipatifs peuvent être des éléments rayonnants, par exemple utilisés dans une antenne rayonnante d'un satellite, qui dissipe de la chaleur récupérée par le fluide circulant dans la boucle thermique 106. Les équipements dissipatifs peuvent être également des amplificateurs permettant d'amplifier des signaux émis et/ou reçu par des éléments rayonnants.

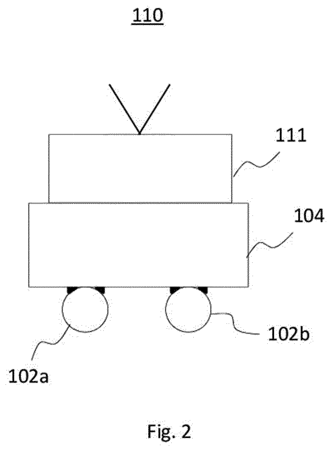

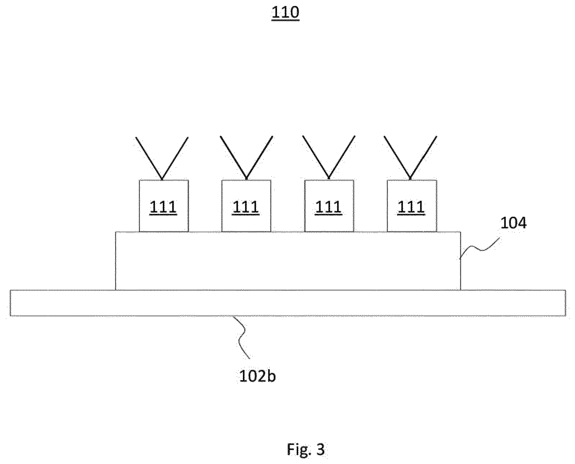

Les figures 2 et 3 représentent une antenne électronique à balayage 110 équipée d'un dispositif d'échange thermique selon l'invention. Une antenne électronique à balayage possède typiquement de nombreux éléments rayonnants 111. Dans l'exemple représenté, les éléments rayonnants 111 sont disposés sur la semelle 104, alignés parallèlement aux tubes 102a et 102b. La figure 2 représente l'antenne 110 en coupe perpendiculairement aux tubes 102a et 102b et la figure 3 représente l'antenne 110 de profil parallèlement aux tubes 102a et 102b. Le bon fonctionnement de l'antenne 110, aussi bien en émission qu'en réception, dépend de la température de chaque élément rayonnant 111. Plus précisément, les caractéristiques électromagnétiques d'un élément rayonnant peuvent varier en fonction de sa température. Pour assurer une bonne homogénéité des caractéristiques des différents éléments rayonnants, il est avantageux qu'ils puissent tous être dans une plage de température étroite. En soumettant chaque élément rayonnant 111 à un échange thermique avec le fluide circulant dans les deux tubes 102a et 102b, on améliore l'homogénéité thermique des différents éléments rayonnants 111. La mise en œuvre de l'invention peut être réalisée avec d'autres équipements et plus généralement tous types d'équipement dissipatif pour lesquels on cherche à améliorer l'homogénéité thermique.

Comme illustré dans la figure 1, la boucle thermique 106 comprend également une pompe 114 configurée pour faire circuler le fluide dans les deux tubes métalliques 102a, 102b avec un débit permettant au fluide d'être dans un état diphasique dans un des deux tubes 102a, 102b. En particulier, tout type de pompe 114 peut être utilisé pour faire circuler le fluide dans la boucle thermique 106, et le fluide circulant dans la pompe 114 est à l'état liquide. Cependant, un état diphasique du fluide permet de garantir un coefficient d'échange thermique élevé entre le fluide et les équipements dissipatifs. Au contraire, lorsque le fluide est à l'état liquide, le coefficient d'échange thermique est faible. Ainsi, la boucle thermique 106 de la présente invention est configurée pour que, lorsque le fluide circule dans la boucle thermique 106 proche des équipements dissipatifs et récupère la chaleur émise, la température du fluide augmente jusqu'à atteindre sa température de saturation. Des conditions d'écoulement du fluide peuvent donc être adaptées pour avoir un état diphasique dans au moins un des deux tubes métalliques 102a, 102b afin d'assurer un état diphasique du fluide sous les équipements dissipatifs 111 placés sur la semelle 104. En effet, le débit de la pompe 114, une dimension des tubes métalliques 102a (un diamètre et/ou une longueur), 102b, un positionnement des équipements sur la semelle 104 peuvent être adaptés afin d'assurer un état diphasique du fluide sous les équipements dissipatifs 111 (c'est-à-dire, dans au moins la totalité du tube métallique 102b).

De plus, la boucle thermique 106 comprend un condenseur 116 pour évacuer de la chaleur du fluide. En particulier, en sortie de l'échangeur 108, le fluide est à l'état diphasique. Cependant, le fluide circule à l'état liquide dans la pompe 114. Ainsi, le condenseur 116 permet d'évacuer la chaleur reçue des équipements dissipatifs 110 et de diminuer la température du fluide en dessous de sa température de saturation afin de retourner à l'état liquide. Le fluide peut donc être à l'état liquide à une sortie du condenseur 116 afin d'être à l'état liquide en circulant dans la pompe 114. Par exemple, le condenseur 116 peut comprendre un ou plusieurs radiateurs permettant d'évacuer la chaleur d'équipements dissipatifs placés sur la semelle métallique 104 récupérée par le fluide vers l'extérieur du dispositif d'échange thermique 100.

Dans l'exemple de la figure 1, deux tubes métalliques 102a, 102b sont représentés. Cependant, dans un autre exemple, trois ou plus tubes métalliques peuvent être utilisés, dépendamment des équipements dissipatifs placés sur la semelle métallique 104 et de la surface de la semelle métallique 104. Par exemple, trois tubes métalliques peuvent être connectés en série, le fluide entrant dans l'échangeur thermique 100 par une entrée du premier tube et sortant par une sortie du troisième tube.

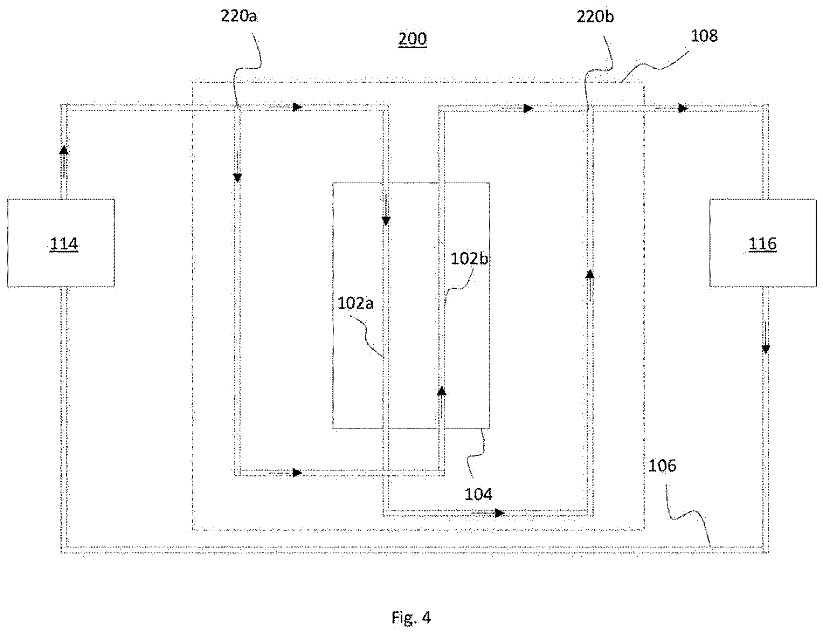

La figure 4 illustre une partie d'un dispositif d'échange thermique 200 selon l'invention. La pompe 114, le condenseur 116 et l'échangeur thermique peuvent être ceux décrits ci-dessus en rapport avec la figure 1. Dans cet exemple, les deux tubes de l'échangeur thermique 108 sont connectés en parallèle. En particulier, l'échangeur thermique 108 comprend une entrée du fluide 220a se séparant en deux connections permettant au fluide de circuler vers le tube métallique 102a et le niveau du tube métallique 102b, l'entrée du fluide au niveau de chaque tube métallique 102a, 102b étant à l'opposé. De même, la sortie du fluide au niveau de chaque tube métallique 102a, 102b étant à l'opposé et se rejoignant par des connections jusqu'à une sortie du fluide 220b commune. Dans l'exemple de la figure 4, deux tubes métalliques 102a, 102b sont représentés. Cependant, dans un autre exemple, trois ou plus tubes métalliques peuvent être utilisés. Par exemple, au lieu l'entrée du fluide 220a peut être séparée en trois ou plus connexions permettant au fluide de circuler vers trois ou plus tubes métalliques. Dans cette configuration, les trois ou plus tubes métalliques ayant une longueur totale L, le fluide doit être à l'état diphasique au maximum lorsqu'il atteint la moitié de la longueur totale L des tubes, afin d'assurer un état diphasique du fluide sous les équipements dissipatifs 111 placés sur la semelle 104.

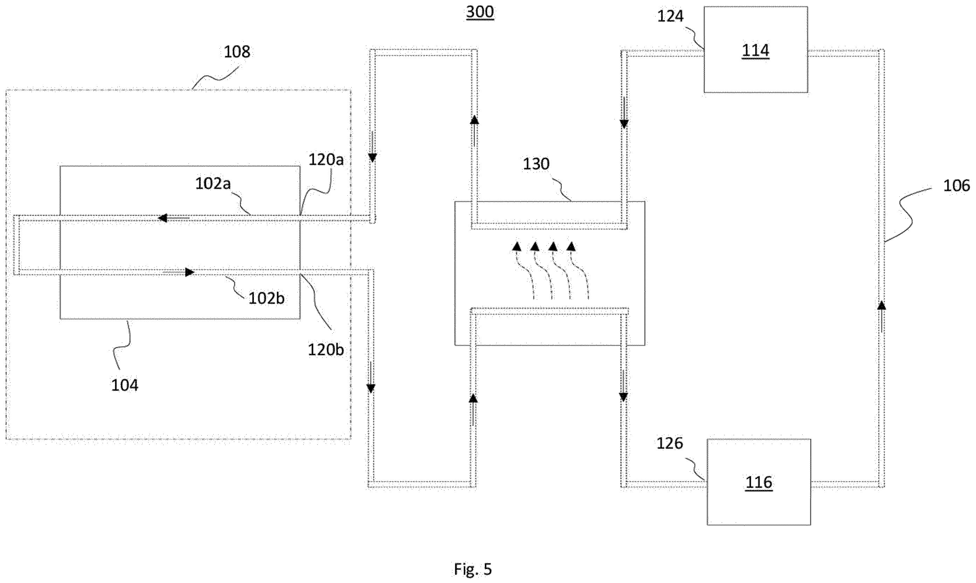

La figure 5 illustre un exemple de dispositif d'échange thermique 300 selon l'invention. La pompe 114, le condenseur 116 et l'échangeur thermique peuvent être ceux décrits ci-dessus en rapport avec la figure 1. Dans cet exemple, les deux tubes métalliques 102a, 102b sont connectés en série. Cependant, dans un autre exemple, les deux tubes métalliques 102a, 102b peuvent être connectés en parallèle. Le dispositif d'échange thermique 300 comprend un réchauffeur 130 configuré pour transférer de l'énergie thermique d'un canal reliant une sortie 120b de l'échangeur 108 à une entrée 126 du condenseur 116 vers un canal reliant une sortie 124 de la pompe 114 vers une entrée 120a de l'échangeur 108. Le réchauffeur 130 permet d'augmenter la température du fluide avant d'entrer dans l'échangeur thermique 108. Ainsi, le réchauffeur 130 peut être utilisé afin d'assurer que le fluide soit à l'état diphasique dans au moins un des deux tubes métalliques 102a, 102b. En particulier, lorsque que le réchauffeur 130 est utilisé dans la boucle thermique 106, le débit de la pompe 114 et/ou la disposition des équipements sur la semelle 111 et ou la longueur des tubes métalliques 102a, 102b peuvent être adaptés afin d'assurer un état diphasique du fluide sous les équipements dissipatifs 111.

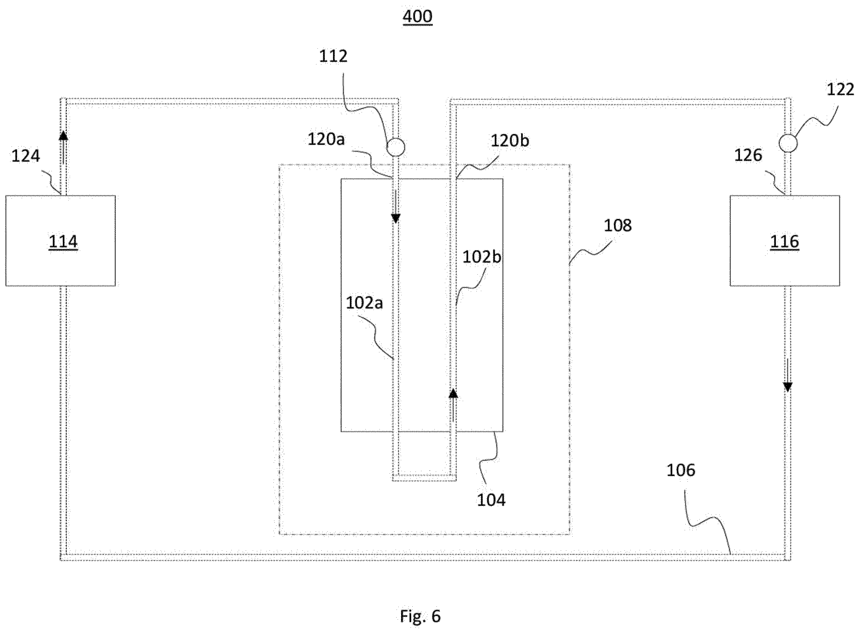

La figure 6 illustre une partie d'un dispositif d'échange thermique 400 selon l'invention. La pompe 114, le condenseur 116 et l'échangeur thermique peuvent être ceux décrits ci-dessus en rapport avec la figure 1. Dans cet exemple, les deux tubes métalliques 102a, 102b sont connectés en série. Cependant, dans un autre exemple, les deux tubes métalliques 102a, 102b peuvent être connectés en parallèle. Le dispositif d'échange thermique 400 comprend un premier capteur de température 112 configuré pour mesurer une première température du fluide circulant entre la pompe 114 et l'échangeur thermique 108. En particulier, le premier capteur 112 est placé dans la boucle thermique 106, entre la sortie 124 de la pompe 114 et l'entrée 120a de l'échangeur thermique 108. Le premier capteur 112 permet de mesurer la température du fluide avant d'entrer dans l'échangeur thermique 108, c'est-à-dire quand le fluide est à l'état liquide (le fluide étant à l'état liquide dans la pompe 114). Ainsi, en mesurant la température du fluide à l'état liquide, le débit de la pompe 114 peut être ajusté afin d'assurer que le fluide atteigne la température de saturation dans au moins un des deux tubes métalliques 102a, 102b.

Le dispositif d'échange thermique 400 peut comprendre un second capteur de température 122 configuré pour mesurer une deuxième température du fluide circulant entre l'échangeur thermique 108 et le condenseur 116. En particulier, le deuxième capteur 122 est placé dans la boucle thermique 106, entre la sortie 120b de l'échangeur thermique 108 et l'entrée 126 du condenseur 126. Comme indiqué ci-dessus, le condenseur permet d'évacuer de la chaleur du fluide afin d'assurer que le fluide soit à l'état liquide dans la pompe 124. Le deuxième capteur 122 de mesurer la température du fluide à l'état diphasique avant d'entrer dans le condenseur 116. Ainsi, en mesurant la température du fluide à l'état diphasique, le débit de la pompe peut être réglé afin d'assurer que le fluide atteigne une température en dessous de la température de saturation en sortie du condensateur. Ainsi, les capteurs 112, 122 peuvent être utilisés afin d'adapter les conditions d'écoulement du fluide et d'assurer un état diphasique du fluide sous les équipements dissipatifs 111.

Dans l'exemple de la figure 6, le dispositif d'échange thermique 400 comprend le premier capteur 112 et le deuxième capteur 122. Cependant, dans un autre exemple, le dispositif d'échange thermique 400 peut comprendre un seul des deux capteurs. De plus dans cet exemple, les deux tubes métalliques sont en série. Cependant, dans un autre exemple, les deux tubes métalliques peuvent être connectés en parallèle. De plus, le dispositif d'échange thermique 400 peut également comprendre le réchauffeur 130 du dispositif d'échange thermique 300 de la figure 5.

Bien que l'invention ait été illustrée et décrite en détail à l'aide d'un mode de réalisation préféré, l'invention n'est pas limitée aux exemples divulgués. D'autres variantes peuvent être déduites par l'homme du métier sans sortir du cadre de protection de l'invention revendiquée. Par exemple, les exemples décrits ci-dessus, l'échangeur thermique 108 comprend deux tubes métalliques 102a, 102b. Cependant, dans d'autres exemples, l'échangeur thermique 108 peut comprendre trois ou plus tubes. De plus, les tubes peuvent être connectés en série ou en parallèle. L'antenne électronique à balayage et plus généralement tout matériel comprenant plusieurs équipements dissipatifs 111, représenté sur les figures 2 et 3 peut comprendre l'un quelconque des exemples de dispositif d'échange thermique décrits à l'aide des autres figures.

## Revendications

1. Dispositif d'échange thermique (100, 200, 300, 400) comprenant une boucle thermique (106) dans laquelle circule un fluide, la boucle thermique comprenant :
un échangeur thermique (108) comprenant au moins deux tubes métalliques (102a, 102b) disposés parallèlement, le fluide circulant dans un premier sens dans un des deux tubes et dans un deuxième sens opposé au premier sens dans l'autre tube ;
une semelle métallique (104) sur laquelle les deux tubes sont fixés ;
une pompe (114) configurée pour faire circuler le fluide dans les deux tubes métalliques avec un débit ; et
un condenseur (116) pour évacuer de la chaleur du fluide ; et
un réchauffeur (130) configuré pour transférer de l'énergie thermique d'un canal reliant une sortie de l'échangeur à une entrée (126) du condenseur vers un canal reliant une sortie de la pompe vers une entrée (120a) de l'échangeur,
où des conditions d'écoulement du fluide sont adaptées pour permettre au fluide d'être dans un état diphasique dans un des deux tubes, les conditions d'écoulement comprenant le débit du fluide et une dimension des tubes.

2. Dispositif d'échange thermique selon la revendication 1, dans lequel les aux moins deux tubes métalliques sont connectés en série.

3. Dispositif d'échange thermique selon la revendication 1, dans lequel les aux moins deux tubes métalliques sont connectés en parallèle.

4. Dispositif d'échange thermique selon l'une des revendications précédentes, dans lequel le dispositif d'échange thermique comprend un premier capteur (112) de température configuré pour mesurer une première température du fluide circulant entre la pompe et l'échangeur thermique.

5. Dispositif d'échange thermique selon l'une des revendications précédentes, dans lequel le dispositif d'échange thermique comprend un second capteur (122) de température configuré pour mesurer une deuxième température du fluide circulant entre l'échangeur thermique et le condenseur.

6. Dispositif d'échange thermique selon l'une des revendications précédentes, dans lequel le fluide circule dans un état liquide dans la pompe.

7. Dispositif d'échange thermique selon l'une des revendications précédentes, dans lequel le fluide est de l'ammoniac.

8. Matériel comprenant un dispositif d'échange thermique selon l'une des revendications précédentes et plusieurs équipements dissipatifs (110) disposés sur la semelle métallique (104), les équipements dissipatifs étant alignés avec les au moins deux tubes métalliques (102a, 102b) de façon à ce que chaque équipements dissipatifs échange de la chaleur avec le fluide circulant dans chacun des au moins deux tubes métalliques (102a, 102b).

## Patentansprüche

1. Wärmetauschvorrichtung (100, 200, 300, 400), umfassend eine Wärmeschleife (106), in der ein Fluid zirkuliert, wobei die Wärmeschleife Folgendes umfasst:
einen Wärmetauscher (108), umfassend mindestens zwei parallel angeordnete Metallrohre (102a, 102b), wobei das Fluid in einer ersten Richtung in einem der beiden Rohre und in einer zweiten, der ersten Richtung entgegengesetzten Richtung, in dem anderen Rohr zirkuliert;
eine Metallgrundplatte (104), an der die beiden Rohre befestigt sind;
eine Pumpe (114), die so konfiguriert ist, dass sie das Fluid mit einer Durchflussrate durch die beiden Metallrohre zirkulieren lässt; und
einen Kondensator (116) zum Abführen von Wärme aus dem Fluid; und
einen Vorwärmer (130), der so konfiguriert ist, dass er Wärmeenergie von einem Kanal, der einen Auslass des Tauschers mit einem Einlass (126) des Kondensators verbindet, an einen Kanal überträgt, der einen Auslass der Pumpe mit einem Einlass (120a) des Tauschers verbindet,
wobei Strömungsbedingungen des Fluids angepasst sind, um dem Fluid zu ermöglichen, in einem der beiden Rohre in einem Zweiphasenzustand zu sein, wobei die Strömungsbedingungen die Durchflussrate des Fluids und eine Abmessung der Rohre umfassen.

2. Wärmetauschvorrichtung nach Anspruch 1, wobei die mindestens zwei Metallrohre in Reihe verbunden sind.

3. Wärmetauschvorrichtung nach Anspruch 1, wobei die mindestens zwei Metallrohre parallel verbunden sind.

4. Wärmetauschvorrichtung nach einem der vorhergehenden Ansprüche, wobei die Wärmetauschvorrichtung einen ersten Temperatursensor (112) umfasst, der so konfiguriert ist, dass er eine erste Temperatur des zwischen der Pumpe und dem Wärmetauscher zirkulierenden Fluids misst.

5. Wärmetauschvorrichtung nach einem der vorhergehenden Ansprüche, wobei die Wärmetauschvorrichtung einen zweiten Temperatursensor (122) umfasst, der so konfiguriert ist, dass er eine zweite Temperatur des zwischen dem Wärmetauscher und dem Kondensator zirkulierenden Fluids misst.

6. Wärmetauschvorrichtung nach einem der vorhergehenden Ansprüche, wobei das Fluid in einem flüssigen Zustand in der Pumpe zirkuliert.

7. Wärmetauschvorrichtung nach einem der vorhergehenden Ansprüche, wobei das Fluid Ammoniak ist.

8. Ausstattung, umfassend eine Wärmetauschvorrichtung nach einem der vorhergehenden Ansprüche und mehrere dissipative Ausrüstungen (110), die auf der Metallgrundplatte (104) angeordnet sind, wobei die dissipativen Ausrüstungen mit den mindestens zwei Metallrohren (102a, 102b) so ausgerichtet sind, dass jede dissipative Ausrüstung Wärme mit dem Fluid austauscht, das in jedem der mindestens zwei Metallrohre (102a, 102b) zirkuliert.

## Claims

1. A heat exchange device (100, 200, 300, 400) comprising a thermal loop (106), in which a fluid circulates, the thermal loop comprising:
a heat exchanger (108) comprising at least two metal tubes (102a, 102b) which are arranged parallel with each other, the fluid circulating in a first direction in one of the two tubes and in a second, opposite direction to the first direction in the other tube;
a metal base plate (104) on which the two tubes are fixed;
a pump (114) which is configured to cause the fluid to circulate in the two metal tubes at a flow rate; and
a condenser (116) for discharging heat from the fluid; and
a heater unit (130) which is configured to transfer thermal energy from a channel which connects an output of the exchanger to an input (126) of the condenser towards a channel which connects an output of the pump to an input (120a) of the exchanger,
wherein flow conditions of the fluid are adapted to allow the fluid to be in a two-phase state in one of the two tubes, the flow conditions comprising the flow rate of the fluid and a dimension of the tubes.

2. The heat exchange device according to claim 1, wherein the at least two metal tubes are connected in series.

3. The heat exchange device according to claim 1, wherein the at least two metal tubes are connected in parallel.

4. The heat exchange device according to any one of the preceding claims, wherein the heat exchange device comprises a first temperature sensor (112) which is configured to measure a first temperature of the fluid which circulates between the pump and the heat exchanger.

5. The heat exchange device according to any one of the preceding claims, wherein the heat exchange device comprises a second temperature sensor (122) which is configured to measure a second temperature of the fluid which circulates between the heat exchanger and the condenser.

6. The heat exchange device according to any one of the preceding claims, wherein the fluid circulates in a liquid state in the pump.

7. The heat exchange device according to any one of the preceding claims, wherein the fluid is ammonia.

8. Hardware comprising a heat exchange device according to any one of the preceding claims and several dissipating equipment items (110) which are arranged on the metal base plate (104), the dissipating equipment items being aligned with the at least two metal tubes (102a, 102b) so that each dissipating equipment item exchanges heat with the fluid which circulates in each of the at least two metal tubes (102a, 102b).
